Europäisches Patentamt

European Patent Office

Office européen des brevets

(11) Publication number: **0 037 930**
**B1**

# EUROPEAN PATENT SPECIFICATION

(45) Date of publication of patent specification: **21.08.85**

(21) Application number: **81102204.5**

(22) Date of filing: **24.03.81**

(51) Int. Cl.⁴: **G 11 C 11/40**, H 01 L 27/10,
H 01 L 29/08, H 01 L 21/26

(54) Semiconductor memory device.

(30) Priority: **25.03.80 JP 37970/80**

(43) Date of publication of application:
**21.10.81 Bulletin 81/42**

(45) Publication of the grant of the patent:
**21.08.85 Bulletin 85/34**

(84) Designated Contracting States:
**DE FR GB**

(56) References cited:
**US-A-3 912 944**

**IEEE JOURNAL OF SOLID-STATE CIRCUITS,
vol. SC-14, no. 5, October 1979, New York, USA
J. LOHSTROH: "The punchthrough device as a
passive exponential load in fast static bipolar
RAM cells" pages 840-844
IBM TECHNICAL DISCLOSURE BULLETIN, vol.
21, no. 1, June 1978 New York, USA D.B.
EARDLEY: "Layout for bipolar random-
accessmemory cell", pages 175-176**

(73) Proprietor: **NEC CORPORATION
33-1, Shiba 5-chome, Minato-ku
Tokyo 108 (JP)**

(72) Inventor: **Suzuki, Masao
c/o Nippon Electric Co., Ltd. 33-1, Shiba
Gochome
Minato-ku Tokyo (JP)**

(74) Representative: **Glawe, Delfs, Moll & Partner
Patentanwälte
Postfach 26 01 62 Liebherrstrasse 20
D-8000 München 26 (DE)**

Courier Press, Leamington Spa, England.

## Description

The present invention relates to a semiconductor memory device employing a transistor formed in a semiconductor substrate, said transistor having a collector region of a first conductivity type, a base region of the opposite conductivity type formed in said collector region, an emitter region of said first conductivity type formed in said base region and an additional emitter region of said first conductivity type formed in the base region and being electrically connected to said collector region for increasing the collector-base capacitance, the collector region being supplied with a predetermined voltage, said base region being supplied with a logic signal, and an output signal in response to said logic signal being derived from said emitter region.

A semiconductor memory device of this kind is known from US—A—39 12 944. According to this prior art an additional emitter region is provided for increasing the collector-base capacitance. This additional emitter region is positioned on both the base region and the collector region and extends across the base-collector junction. By this known measure a memory device is obtained which combines a small required surface with very good operation as for the signal-to-noise ratio and cross talk as well as for the hold-characteristic of the memory cell.

However, the known memory device with the additional emitter extending across the base-collector junction has the disadvantage, that the electrical characteristics of the transistor, which depend on the base-collector junction, are affected by this additional region. For example, crystalline dislocations will easily be caused in the base-collector junction near this region. This may produce an increase of the leakage current of the base-collector junction and a lowering of the breakdown-voltage of the base-collector junction.

It is therefore an object of the present invention to provide a semiconductor memory device according to the preamble of the main claim in which these disadvantages are avoided.

This object is solved according to the present invention by the features, that said additional emitter region is formed entirely within the base region and that the additional emitter region and the collector region are connected by a conductor which is insulated from the base-collector junction and makes ohmic contact with the additional emitter and collector regions.

According to the invention the additional emitter region is formed within the base region only and does not extend across the base-collector junction. Since the additional emitter region is connected to the collector region via separate external conductor, the electrical characteristics of the base-collector junction are not effected by the additional emitter. Particularly, the leakage current will not be increased and the breakthrough-voltage will not be lower. This advantage clearly outweighs any additional effort in manufacture.

In a preferred embodiment of the invention the conductor is formed by a layer of polycrystalline silicon and is connected to a highly doped region of the same conductivity type as the collector.

The above-mentioned and other features and advantages of the present invention will become more apparent by reference to the following description of preferred embodiments of the present invention taken in conjunction with the accompanying drawings, wherein:

Fig. 1 is a circuit diagram of a heretofore known memory cell,

Fig. 2 is a cross-section view showing a transistor structure used in the known memory cell as illustrated in Fig. 1,

Fig. 3 is a circuit diagram of a memory cell according to the present invention,

Fig. 4 is a plan view of a memory cell according to a first embodiment of the present invention,

Fig. 5 is a cross-section view showing a transistor structure available in the memory cell of Fig. 4.

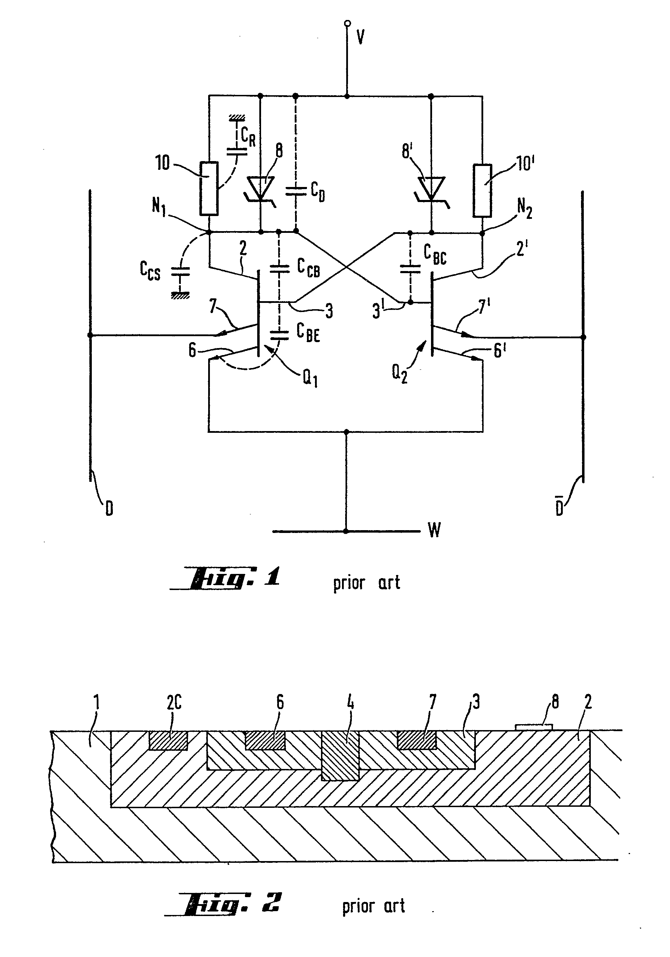

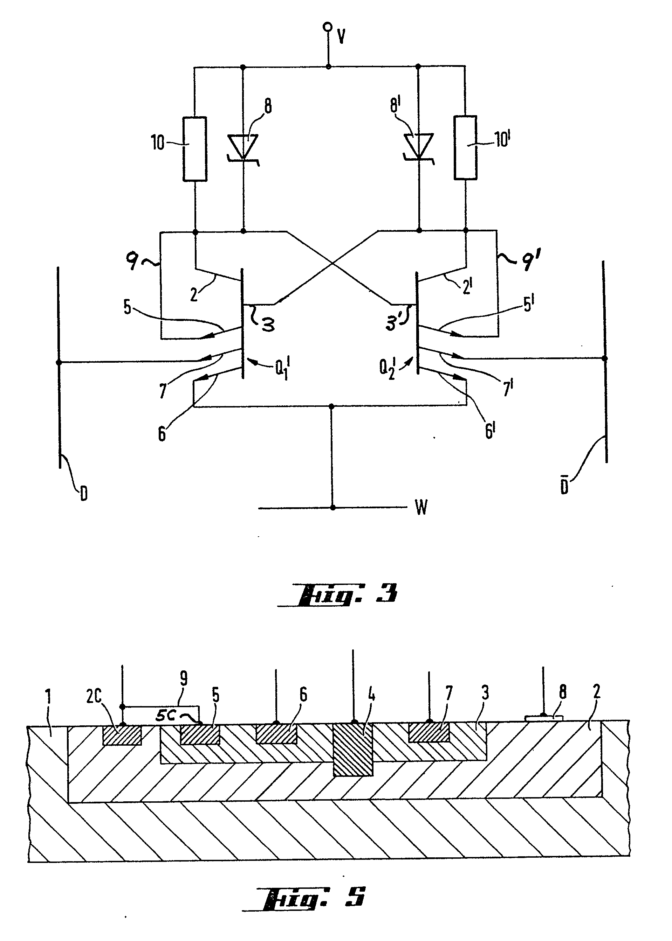

At first, description will be made on a bipolar memory cell in the prior art with reference to Figs. 1 and 2. An equivalent circuit of a bipolar memory cell in the prior art is depicted in Fig. 1. As shown in Fig. 1, respective bases 3, 3' and collectors 2, 2' of multi-emitter transistors $Q_1$ and $Q_2$ each having two emitters are cross-connected at nodes $N_1$ and $N_2$. An emitter 7 of the transitor $Q_1$ is connected to a true date line D, while an emitter 7' of the transistor $Q_2$ is connected to a complementary data line $\overline{D}$. The other emitters 6 and 6' of the respective transistors $Q_1$ and $Q_2$ are connected in common to a word line W. A collector 2 of the transistor $Q_1$ is connected to a voltage source V through a resistor 10 and a Schottky barrier diode (SBD) 8. Likewise a collector 2' of the other transistor $Q_2$ is connected to the voltage source V through a resistor 10' and a SBD 8'. A detailed structure of the multi-emitter transistor $Q_1$ in Fig. 1 is illustrated in Fig. 2. In Fig. 2, component parts corresponding to those shown in Fig. 1 are designated by like reference numerals. Of course, the transistor $Q_2$ has exactly the same structure as the illustrated transistor $Q_1$.

The transistor illustrated in Fig. 2 includes a P-type substrate 1, an N-type collector region 2, a P-type base region 3 formed in this collector region 2, further a $P^+$-type base ohmic contact 4 and $N^+$-type emitters 6 and 7 both formed in the base region 3, and a collector ohmic contact 2C formed within the collector region 2, and on the collector region 2 is provided a metallic layer 8 for forming a Schottky barrier diode.

Considering now a parasitic capacitance $C_C$ associated with one collector node $N_1$, it is composed of a capacitance $C_{CS}$ between the collector and substrate, a capacitance $C_{CB}$ between the collector 2 and base 3, a capacitance $C_{BC}$ between the base 3' and collector 2' of the opposite side transistor $Q_2$, a capacitance 2 $C_{BE}$ between the base 3 and first and second emitters 6 and 7, a capacitance $C_D$ of the Schottky barrier diode 8, and a capacitance $C_R$ between the resistor 10 and substrate. The capacitance between the base and collector is effective nearly double because of a known mirror effect, and so, assuming that $C_{BC} \simeq C_{CB}$ for the sake of simplicity, the parasitic capacitance $C_C$ can be represented as follows:

$$C_C = 4 \ C_{BC} + 2 \ C_{BE} + C_{CS} + C_D + C_R \qquad (1)$$

The typical value of the capacitance $C_C$ is about 10 PF when the memory all is formed on an area having a width of 40 μm and a length of 60 μm.

Now one preferred embodiment of the present invention will be explained with reference to Figs. 3 to 5.

As shown in Fig. 3, according to the present invention, transistors $Q_1'$ and $Q_2'$ each having three emitters are used. A third emitter 5 of the transistor $Q_1'$ is connected to its collector 2, and a third emitter 5' of the transistor $Q_2'$ is connected to its collector 2'. The other circuit construction in Fig. 3 is similar to that shown in Fig. 1, and emitters 6 and 6' are connected in common to a word line W, while emitters 7 and 7' are respectively connected to data lines D and $\overline{D}$. Now in the transistors $Q_1'$ and $Q_2'$ the emitters 5 and 5' connected to the collectors of the same transistors are in a reverse-biased condition with respect to the bases 3 and 3' of the same transistors, and hence current paths from the emitters 5 and 5' to the bases 3 and 3' are not present. Therefore, it is obvious that the circuit operation of the memory cell in Fig. 3 is basically identical to that of the memory cell in the prior art shown in Fig. 1. However, it is to be noted that in this case since the emitters 5 and 5' are held in a back-biased condition with respect to the bases 3 and 3', they have the functions of capacitances. Accordingly, the collectors 2 and 2' of the transistors $Q_1'$ and $Q_2'$ would be added with capacitances due to the emitters 5 and 5'. Therefore the quantities of electric charge stored at the collectors 2 and 2', respectively, in accordance with the information to be stored, would increase by the amount corresponding to the increase of capacitance due to the emitters 5 and 5', and hence the capability of holding the memory information can be widely enhanced.

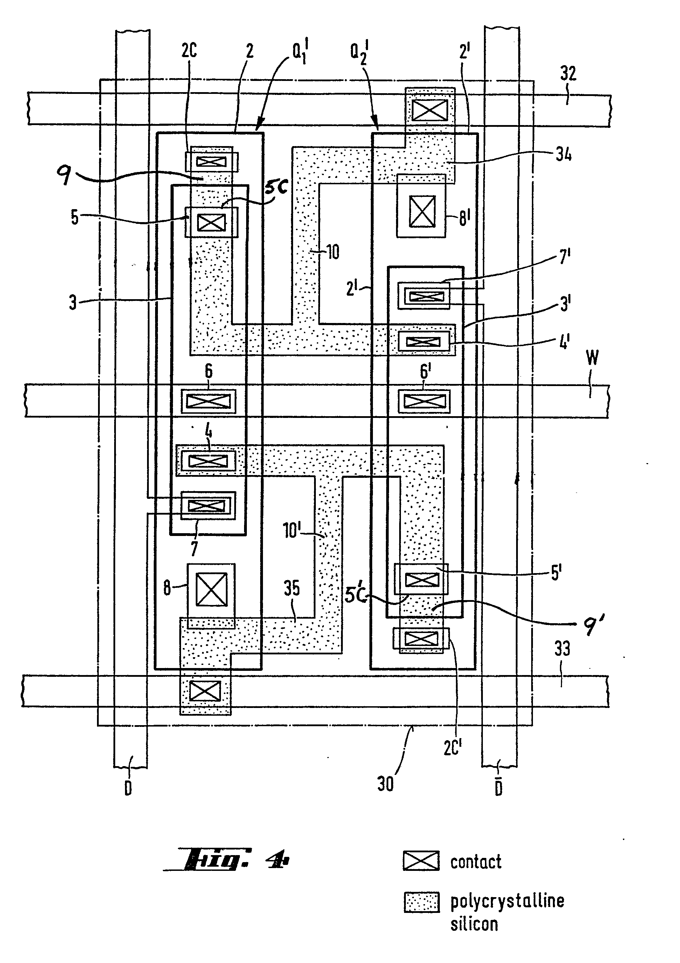

With reference to Fig. 4, first layout example of the memory cell shown in Fig. 3 will be explained. In this figure, the same reference numerals are employed for portions corresponding to those in Fig. 3.

A memory cell is fabricated on a P-type semiconductor area 30 having a width of 40 μm and a length of 60 μm. The transistor $Q_1'$ is composed of an N-type collector region 2, a P-type base region 3, and three N-type emitter regions 5, 6 and 7. $P^+$ base contact regions 4 and 4' are formed respectively in the base regions 3 and 3'. In the collector region 2, an $N^+$ region 2C is formed for a contact purpose. The transistor $Q_2'$ has a similar structure whose layout of the respective regions is a rotational symmetrical relation to that of the transistor $Q_1$. The pair of digit lines D and $\overline{D}$ are made of aluminium wirings extending in a longitudinal direction. The word line W is made of an aluminium wiring extending in a lateral direction. The power voltage line is realized by two separate aluminum wirings 32 and 33 extended in the lateral direction.

The base contact region 4 of the transistor $Q_1'$ is connected to the third emitter 5' and the collector contact region 2C' by a polycrystalline silicon wiring 9' which is highly doped with P-type impurity. This wiring 9' is very highly doped and hence does not form an effective PN barrier with the $N^+$-type region 2C' so that ohmic connection therebetween is obtained. Similarly, the collector contact region 2G and the emitter region 5' of the transistor $Q_1'$ are connected to the base contact region 4' of the transistor $Q_2'$ by a polycrystalline silicon wiring 9 which is highly doped with a P-type impurity.

The resistors 10 and 10' are made of a polycrystalline silicon wirings which are slightly doped with a P-type impurity. Wirings 34 and 35 respectively for connecting the wiring 32 and the register, and the wiring 33 and the register 10' are made of highly N-type doped polycrystalline silicon wirings. The Schottky diodes 8 and 8' are formed by platinum layers contacted to the collector regions 2 and 2' through contact holes.

Then, a further detailed practical structure of the transistor $Q_1'$ will be explained with reference to Fig. 5. It is to be noted that the structure of the other transistor $Q_2'$ is also identical to the illustrated structure. In Fig. 5, components parts corresponding to those shown in Fig. 3 are designated by like reference numerals.

With reference to Fig. 5, as compared to the structure shown in Fig. 2, the third emitter 5 and a conductor 9 for connecting the third emitter contact 5C to a collector contact region 2C are newly added. Normally, the third emitter 5 is formed simultaneously with emitters 6 and 7, and so, increase in manufacturing step does not occur. Here, considering the effect of the provision of the third emitter, this emitter forms a junction capacitance $C_{BE}$ between the base region 3 and the emitter, and in view of the circuit construction this capacitance $C_{BE}$ is added in parallel to the capacitance $C_{BC}$ between the collector region 2 and the base region 3. Hence, it has an effect of increasing a capacitance by $4 \times C_{BE}$ than Equation (1) above. Moreover, a capacitance per unit area is largest for the capacitance between the base and the emitter having a high impurity concentration, and hence, although the third emitter 5 is small in area, it has a large effect. It is also to be noted that the increments of capacitances $\Delta C_{CS}$ and $\Delta C_{BC}$ caused by the increase of the junction areas between the collector and substrate and between the base and collector, respectively, serve as increments of the capacitances associated with the collector nodes $N_1$ and $N_2$ of the respective transistors. Therefore they are effective for protecting the memory cell from the α-ray error.

Thus, the resultant increase $\Delta C_C$ of the collector node capacitance becomes

$$\Delta C_C = 4 \times C_{BE} + \Delta C_{CS} + \Delta C_{BC} \qquad (2)$$

According to the above embodiment, the typical value of the total capacitance of the collector node is about 12 PF. Thus, increase of about 2 PF in the collector node capacitance can be achieved.

An area of a memory cell is substantially dependent upon the areas of the collectors of the two transistors $Q_1'$ and $Q_2'$. As a method for straightforwardly increasing a capacitance associated with a collector, it may be conceived to enlarge the area of the collector per se. However, this will straightly bring about increase of the area of the memory cell, and so, it is not favorable. According to the present invention, it is only necessary to additionally provide one emitter in each transistor, and the base region where the emitter is to be additionally provided, generally has a margin in space, so that the increase of the collector area caused by additionally providing an emitter in the base region is very small. According to the present invention, the capacitance associated with the collector can be increased by about 20% as compared to the transistor structure shown in Fig. 2. It has been proved that if the collector load capacitance is increased by about 20%, then the probability of occurrence of the soft error due to α-rays on the like can be reduced by a factor of $1/10^2$.

## Claims

1. A semiconductor memory device employing a transistor formed in a semiconductor substrate (1), said transistor having a collector region (2) of a first conductivity type, a base region (3) of the opposite conductivity type formed in said collector region (2), an emitter region (6) of said first conductivity type formed in said base region (3), and an additional emitter region (5) of said first conductivity type formed in the base region (3) and being electrically connected to said collector region (2) for increasing the collector-base capacitance, the collector (2) being supplied with a predetermined voltage, said base region (3) being supplied with a logic signal, and an output signal in response to said logic signal being derived from said emitter region (6), characterized in that said additional emitter region (5) is formed entirely within the base region (3) and that the additional emitter region (5) and the collector region (2) are connected by a conductor (9) which is insulated from the base-collector junction and makes ohmic contact (5C, 2C) with the additional emitter (5) and collector region (2).

2. A semiconductor memory device as claimed in claim 1, characterized in that said conductor (9) is formed by a layer of polycrystalline silicon.

3. A semiconductor memory device as claimed in claim 1, characterized in that said conductor (9) is connected to a highly doped region (2C) of the same conductivity type as that of the collector (2) formed in said collector (2) without contact to the base-collector junction.

## Revendications

1. Dispositif à mémoire semi-conductrice employant un transistor formé dans un substrat semi-conducteur (1), ce transistor comportant une région du collecteur (2) d'un premier type de conductibilité, une région de base (3) du type de conductibilité opposé formée dans la région du collecteur (2), une région de l'émetteur (6) du premier type de conductibilité formée dans cette région de base (3), et une région supplémentaire de l'émetteur (5) du premier type de conductibilité formée dans la région de base (3) et reliée électriquement à la région du collecteur (2) pour augmenter la capacité collecteur-base, le collecteur (2) étant alimenté avec une tension prédéterminée, la région de base (3) étant alimentée avec un signal logique, et un signal de sortie en réponse au signal logique étant extrait à la région de l'émetteur (6), caractérisé en ce que la région supplémentaire de l'émetteur (5) est formée entièrement à l'intérieur de la région de base (3), et en ce que la région supplémentaire de l'émetteur (5) et la région du collecteur (2) sont reliées par un conducteur (9) qui est insolé de la jonction base-collecteur et réalise un contact ohmique (5C, 2C) avec l'émetteur supplémentaire (5) et la région du collecteur (2).

2. Dispositif à mémoire semiconductrice selon la revendication 1, caractérisé en ce que le conductrice (9) est formé d'une couche de silicium polycristallin.

3. Dispositif à mémoire semi-conductrice selon la revendication 1, caractérisé en ce que le conducteur (9) est connecté à une région hautement dopée (2C) du même type de conductibilité que le collecteur (2) formé dans le collecteur (2) sans contact avec la jonction base-collecteur.

## Patentansprüche

1. Halbleiterspeichervorrichtung mit einem in einem Halbleitersubstrat (1) ausgebildeten Transistor, welcher einen Kollektorbereich (2) eines ersten Leitfähigkeitstyps, einen Basisbereich (3) des entgegengesetzten Leiffähigkeitstyps auf dem Kollektorbereich (2), einen Emitterbereich (6) des ersten Leitfähigkeitstyps auf dem Basisbereich (3), und einem zuzätzlichen Emitterbereich (5) des ersten Leitfähigkeitstyps auf dem Basisbereich (3) aufweist, welcher elektrisch mit dem Kollektorbereich (2) verbunden ist, um die Kollektor-Basis-Kapazität zu erhöhen, wobei der Kollektor (2) mit einer vorbestimmten Spannung versorgt wird, der Basisbereich (3) mit einem logischen Signal beaufschlagt wird, und vom Emitterbereich (6) in Antwort auf das logische Signal ein Ausgangssignal abgezogen wird, dadurch gekennzeichnet, daß der zusätzliche

7 — 0 037 930 — 8

Emitterbereich (5) zur Gänze innerhalb des Basisbereichs (4) ausgebildet ist und daß der zusätzliche Emitterbereich (5) und der Kollektorbereich (2) über einen Leiter (9) miteinander verbunden sind, der vom Basiskollektorübergang isoliert ist und einen ohmschen Kontakt (5C, 2C) mit dem zusätzlichen Emitterbereich (5) und dem Kollektorbereich (2) hat.

2. Halbleiterspeichervorrichtung nach Anspruch 1, dadurch gekennzeichnet, daß der Leiter (9) durch eine Schicht aus polykristallinen Silizium gebildet ist.

3. Halbleiterspeichervorrichtung nach Anspruch 1, dadurch gekennzeichnet, daß der Leiter (9) mit einem hoch-dotierten Bereich (2C) des gleichen Leitfähigkeitstyps wie der Kollektor (2) verbunden ist, welcher auf dem Kollektor (2) ausgebildet ist ohne Kontakt zum Basiskollektorübergang.

0 037 930

*Fig. 1*    prior art

*Fig. 2*    prior art

1

_Fig. 3_

_Fig. 5_

**Fig: 4.**

⊠ contact

▦ polycrystalline
silicon